# EUROPÄISCHE PATENTSCHRIFT

(11) **EP 4 185 842 B1**
(45) Veröffentlichungstag und Bekanntmachung des Hinweises auf die Patenterteilung: **29.05.2024**
(21) Anmeldenummer: 21740467.2
(22) Anmeldetag: 02.07.2021
(51) Int. Cl.: H01L 25/16, H01L 33/46, G01D 5/347, H01L 31/16, H01L 33/20

(54) **VERFAHREN ZUR HERSTELLUNG EINES OPTISCHEN POSITIONSENCODERS**
METHOD FOR PRODUCING AN OPTICAL POSITION ENCODER
PROCÉDÉ DE FABRICATION D'UN CODEUR OPTIQUE DE POSITION

(30) Priorität: 23.07.2020 DE 102020119511
(43) Veröffentlichungstag der Anmeldung: 31.05.2023
(73) Patentinhaber: iC-Haus GmbH, 55294 Bodenheim (DE)
(72) Erfinder: GALLOUCH, Monir, 68649 Groß-Rohrheim Hessen (DE)
(74) Vertreter: Feder Walter Ebert
(86) Internationale Anmeldenummer: PCT/EP2021/068312
(87) Internationale Veröffentlichungsnummer: WO 2022/017761

(56) Entgegenhaltungen:
- DE-A1-102012 107 578
- DE-A1-102014 112 540
- DE-A1-102015 103 253
- US-A1- 2013 207 126
- US-A1- 2013 292 706

## Beschreibung

Die vorliegende Erfindung betrifft ein Verfahren zur Herstellung eines optischen Positionsencoders mit einem optoelektronischen Bauelement und mit einer von einer LED-Lichtquelle des optoelektronischen Bauelements beleuchteten Maßverkörperung, bei welchem eine LED-Lichtquelle derart in ein Mold-Gehäuse eingemoldet wird, dass eine Lichtaustrittsfläche der LED-Lichtquelle nach außen freiliegt. Einen weiteren Gegenstand der Erfindung bildet ein optischer Positionsencoder mit einem optoelektronischen Bauelement mit einem Mold-Gehäuse, in dem eine LED-Lichtquelle derart angeordnet ist, dass eine Lichtaustrittsfläche der LED-Lichtquelle nach außen freiliegt, und mit einer von der LED-Lichtquelle des optoelektronischen Bauelements beleuchteten Maßverkörperung.

Derartige optoelektronische Bauelemente werden üblicherweise in optischen Positionsencodern verwendet, um Bewegungen von Bauteilen erfassen zu können. Hierzu wird an dem Bauteil eine Maßverkörperung angeordnet, welche von der LED-Lichtquelle des optoelektronischen Bauelements angestrahlt wird. Die Maßverkörperung ist dabei derart ausgebildet, dass das auf die Maßverkörperung treffende Licht der LED-Lichtquelle nach einem bestimmten Muster moduliert wird. So kann die Maßverkörperung beispielsweise aus hellen und dunklen Bereichen bestehen, wobei insbesondere ein Strichmuster von Vorteil ist. Das modulierte Licht kann dann von einem Abtastempfänger in Form mindestens eines Lichtsensors detektiert werden. Auf diese Weise lassen sich weitgehend Sinus- und Cosinus-Signalformen erzeugen, welche ausgewertet werden können und so Aufschluss über die Position des Bauteils geben.

Ein solcher Positionsencoder kann entweder als linearer Positionsencoder, welcher Linearbewegungen des Bauteils erfasst, oder als Rotationsencoder zur Erfassung von Drehbewegungen des Bauteils ausgebildet sein. Dementsprechend kann die Maßverkörperung aus parallel zueinander angeordneten Strichen bei einer insgesamt rechteckigen Form ausgebildet sein oder als kreisförmige Scheibe mit radial verlaufenden Strichen. Darüber hinaus kann der Positionsencoder entweder als inkrementeller Encoder oder aber auch als absoluter Encoder ausgebildet sein. Bei einem inkrementellen Encoder kann zu Beginn eines Messvorgangs zusätzlich eine Referenzierung durchgeführt werden, um eine lokale Absolut-Information zu erhalten. Dies ist bei einem über den gesamten Abtastbereich absoluten Encoder nicht erforderlich.

Auch die Maßverkörperung kann je nach Anwendungsfall unterschiedlich ausgebildet sein. So sind zum einen Durchlichtanordnungen bekannt, bei welchen die Maßverkörperung zwischen der LED-Lichtquelle und dem das modulierte Licht empfangenden Lichtsensor angeordnet ist. Die Hellflächen werden dann zumeist durch schlitzförmige lichtdurchlässige Bereiche der Maßverkörperung gebildet. Alternativ kann die Maßverkörperung auch als reflexive Anordnung ausgebildet sein, wobei dann das Licht der LED-Lichtquelle an den Hellfeldern reflektiert wird und zum Sensor gelangt.

Um die empfindlichen mikroelektronischen Komponenten des Bauelements vor Beeinträchtigungen zu schützen, ist es bekannt, diese Komponenten in einem Mold-Gehäuse anzuordnen, welches das Bauteil insgesamt umschließt.

Unter dem Begriff "Molding" wird dabei im Allgemeinen ein Urformverfahren verstanden und im Besonderen ein Spritzgussverfahren, bei welchem flüssige Materialien in eine Form, welches auch als Spritzgusswerkzeug bezeichnet wird, unter Druck eingespritzt werden. In der Form geht der Werkstoff durch Abkühlung oder eine Vernetzungsreaktion wieder in den festen Zustand über und wird nach dem Öffnen des Werkzeuges als Fertigteil entnommen. Im Spritzgussverfahren hergestellte Gehäuse bieten insbesondere im Hinblick auf die Verarbeitungsgeschwindigkeit und Formgebung Vorteile gegenüber Gehäusen, die durch reines Gießen, dem sogenannten "Casting", hergestellt werden, bei welchem ein flüssiger Werkstoff in eine Form gegossen wird und dort erstarrt. Allerdings sind die einzelnen Bauteile beim Molding deutlich höheren Drücken ausgesetzt, weshalb nicht jedes Bauteil für dieses Herstellungsverfahren geeignet ist.

Eine Anordnung, bei welcher die einzelnen Komponenten in einem Mold-Gehäuse angeordnet sind, ist beispielsweise aus der DE 10 2012 107 578 A1 bekannt. Die LED-Lichtquelle befindet sich dort auf einem Träger und wird allseitig von dem Mold-Gehäuse umschlossen. Um eine definierte Abstrahlung des Lichtes der LED-Lichtquelle nach oben zu ermöglichen sowie Beschädigungen der LED-Lichtquelle während des Herstellungsprozesses zu verhindern, befindet sich oberhalb der LED-Lichtquelle eine strukturierte Glasplatte.

Solche Bauteile haben sich im Einsatz als reine LED-Beleuchtung zwar durchaus bewährt, jedoch hat es sich bei solchen Anordnungen als nachteilig erwiesen, dass es für den Einsatz in Positionsencodern zu Beeinträchtigungen der Lichtabstrahlung durch die oberhalb der LED-Lichtquelle angeordnete Glasplatte kommen kann. Denn zum einen können unerwünschte Brechungen der Lichtstrahlen an den Übergängen zwischen LED-Lichtquelle und Glasplatte sowie zwischen Glasplatte und der Umgebung auftreten. Zum anderen können Reflexionen auftreten, so dass beispielsweise Fremdlicht ebenfalls in Richtung der Maßverkörperung gelenkt wird und somit zu einer Verfälschung von Messergebnissen führt.

Zur Vermeidung von Beeinträchtigungen der Lichtabstrahlung durch eine oberhalb der LED-Lichtquelle angeordnete Glasplatte ist es beispielsweise aus der DE 10 2015 103 253 A1 bekannt, eine Lichtaustrittsfläche der LED-Lichtquelle, über welche das Licht aus der LED-Lichtquelle austritt, nach außen freiliegend auszubilden. Durch das Freiliegen der Lichtaustrittsfläche nach außen befindet sich diese nicht mehr innerhalb des Mold-Gehäuses, wodurch neben einer Vereinfachung des Aufbaus eine Abstrahlung der LED-Lichtquelle in alle Richtungen erreicht werden kann. Mögliche Brechungen, Abschattungen, Verkopplungen durch Streulicht oder sonstige Beeinträchtigungen können durch die Vermeidung von auf oder oberhalb der LED-Lichtquelle angeordneten Elementen verhindert werden.

Die Abstrahleigenschaften der LED-Lichtquelle werden von den genauen Abmessungen der Lichtaustrittsfläche der LED-Lichtquelle beeinflusst, welche wiederum im Wesentlichen von dem Herstellungsverfahren und den Fertigungstoleranzen bei der Herstellung der LED-Lichtquelle bestimmt werden. Es kommt dabei nicht nur zu Unterschieden zwischen LED-Lichtquellen verschiedener Hersteller, sondern auch zu Unterschieden zwischen LED-Lichtquellen unterschiedlicher Chargen des gleichen Herstellers und sogar zwischen einzelnen LED-Lichtquellen der gleichen Charge. Die Unterschiede der Lichtaustrittsfläche beeinflussen die Signalqualität in einem Positionsencoder und begrenzen die Auflösung des optoelektronischen Bauelements, wobei insbesondere große Lichtaustrittsflächen in einer geringen Auflösung resultieren.

Vor diesem Hintergrund stellt sich die Erfindung die **Aufgabe**, ein Verfahren zur Herstellung eines optischen Positionsencoders sowie einen optischen Positionsencoder anzugeben, welche die Abstrahleigenschaften der LED-Lichtquelle zur Erzielung höherer Auflösungen verbessern.

Diese Aufgabe wird bei einem Verfahren der eingangs genannten Art dadurch g e l ö s t, dass die Lichtaustrittsfläche beschichtet wird und zur Bereitstellung eines Lichtaustrittsfensters bereichsweise entschichtet wird.

Indem die LED-Lichtquelle, bei welcher es sich insbesondere um einen Halbleiter-LED-Chip handelt, selbst beschichtet wird, kann diese weiterhin nach außen freiliegen. Die Beschichtung bildet so eine Außenfläche der beschichteten LED-Lichtquelle. Unerwünschte Brechungen der Lichtstrahlen an den Übergängen zwischen der LED-Lichtquelle und einem Abdeckelement, wie einer Glasplatte, sowie zwischen dem Abdeckelement und der Umgebung können vermieden werden. Die Auflösung des optoelektronischen Bauelements wird nicht mehr von dem Herstellungsverfahren und den Fertigungstoleranzen bei der Herstellung der unbeschichteten LED-Lichtquellen und insbesondere eines Halbleiterkristalls des Halbleiter-LED-Chips, sondern von der Beschichtung und der Entschichtung sowie den Abmessungen des Lichtaustrittsfensters bestimmt. Die Toleranzen bei der Beschichtung und der Entschichtung können geringer als die Fertigungstoleranzen sein. Es können bessere Abstrahleigenschaften und insbesondere eine bessere Signalqualität sowie höhere Auflösungen erzielt werden.

Die LED-Lichtquelle kann durch die beschichtete Lichtaustrittsfläche und das entschichtete Lichtaustrittsfenster mit einer integrierten Maskierung ausgestattet werden. Durch die Entschichtung kann ein das Lichtaustrittsfensters präzise gefertigt werden und insbesondere scharfe Ränder und damit verbesserte Abstrahleigenschaften aufweisen.

Das Verfahren kann mit LED-Lichtquellen unterschiedlicher Hersteller und/oder Chargen durchgeführt werden. Durch die Beschichtung und Entschichtung können trotz unterschiedlicher Herstellungsverfahren und den Fertigungstoleranzen der verwendeten LED-Lichtquellen optoelektronische Bauteile mit gleichbleibenden Abstrahleigenschaften hergestellt werden. Es kann ein Lichtaustrittsfenster mit Abmessungen erzielt werden, welche im Wesentlichen unabhängig von der verwendeten LED-Lichtquelle sind und unterhalb von den Abmessungen der Lichtaustrittsfläche liegen. Bei einer Serienherstellung mehrerer optoelektronischer Bauteile kann trotz den Unterschieden zwischen den einzelnen LED-Lichtquellen ein gleichbleibendes Lichtaustrittsfenster bei allen optoelektronischen Bauteile erzielt werden.

Gemäß einer Ausgestaltung der Erfindung kann die Lichtaustrittsfläche teilflächig beschichtet werden. Insbesondere ein Teil der Lichtaustrittsfläche, welcher zur Bereitstellung des Lichtaustrittsfensters genutzt werden soll, kann von vornherein unbeschichtet bleiben. Zur Bereitstellung des Lichtaustrittsfensters können die beschichteten Teile der Lichtaustrittsfläche bereichsweise entschichtet werden. Insbesondere die Ränder des Lichtaustrittsfensters, um die unbeschichteten Teile der Lichtaustrittsfläche herum, können zur Erzielung scharfer Ränder des Lichtaustrittsfensters entschichtet werden. Durch die teilflächige Beschichtung kann, insbesondere bei größeren Lichtaustrittsfenstern, eine material- und zeitsparende Verfahrensdurchführung ermöglicht werden.

Bevorzugt wird das Mold-Gehäuse durch eine zum Einmolden der LED-Lichtquelle genutzte Mold-Masse gebildet. Die Mold-Masse kann hierzu in ein Spritzgusswerkzeug eingespritzt werden, in welcher die LED-Lichtquelle bereits angeordnet wurde. Die Fertigung des Mold-Gehäuses und das Einmolden der LED-Lichtquelle kann auf zeitsparende Weise in einem Verfahrensschritt erfolgen.

In vorteilhafter Weise wird die Lichtaustrittsfläche vollflächig oder teilflächig mit einer, insbesondere im Wesentlichen lichtundurchlässigen und/ oder reflektierenden, Beschichtung beschichtet. Bei einer vollflächigen Beschichtung der Lichtaustrittsfläche kann das Lichtaustrittsfenster durch eine entsprechende Entschichtung frei auf der Lichtaustrittsfläche positioniert werden, ohne dass die Position eines unbeschichteten Teils der Lichtaustrittsfläche berücksichtigt werden muss. Durch eine im Wesentlichen lichtundurchlässige Beschichtung kann ein Lichtaustritt aus den beschichteten Teilen der Lichtaustrittsfläche verhindert werden. Ein Austreten von Licht aus der LED-Lichtquelle kann durch eine lichtundurchlässige Beschichtung auf das Lichtaustrittsfenster örtlich beschränkt werden. Über die Abmessungen des Lichtaustrittsfensters können die Abstrahleigenschaften der LED-Lichtquelle im Wesentlichen unabhängig von den Abmessungen der gesamten Lichtaustrittsfläche festgelegt werden. Eine reflektierende Beschichtung, insbesondere eine in Richtung des Inneren der LED-Lichtquelle spiegelnde Beschichtung, ermöglicht eine Lichtreflexion in das Innere der LED-Lichtquelle, wenn einzelne Lichtstrahlen auf die Beschichtung und nicht auf das entschichtete Lichtaustrittsfenster treffen. Durch die Reflexion in das Innere der LED-Lichtquelle kann die Lichtausbeute der LED-Lichtquelle erhöht werden. Insbesondere bei einer Mehrfachreflexion kann ein in das Innere der LED-Lichtquelle reflektierter Lichtstrahl derart erneut reflektiert werden, dass er über das Lichtaustrittsfenster aus der LED-Lichtquelle austreten kann. Eine Bündelung des von der LED-Lichtquelle erzeugen Lichts auf das Lichtaustrittsfenster kann auf diese Weise erzielt werden.

Die Lichtaustrittsfläche kann vollflächig oder teilflächig mit mehreren Beschichtungen beschichtet werden, so dass sich insbesondere eine mehrlagige Beschichtung der Lichtaustrittsfläche ergibt. Durch mehrere Beschichtungen und insbesondere eine mehrlagige Beschichtung können die Effekte der einzelnen Beschichtungen, insbesondere zur Verbesserung der Abstrahleigenschaften der LED-Lichtquelle, auf einfache Weise miteinander kombiniert werden.

Die Beschichtung und/oder die Beschichtungen können insbesondere aus nicht-organischen Verbindungen bestehen.

In diesem Zusammenhang ist es besonders vorteilhaft, wenn die Lichtaustrittsfläche mit einer metallischen Beschichtung beschichtet wird, insbesondere mit einer Beschichtung aus Gold oder aus einer Gold-Legierung. Metallische Beschichtungen, insbesondere Beschichtungen aus Gold oder aus einer Gold-Legierung, können auf verfahrenstechnisch einfache Weise auf die Lichtaustrittsfläche aufgebracht werden. In materialsparender Weise lassen sich mit metallischen Beschichtungen dünne und damit wenig auftragende Beschichtungen der Lichtaustrittsfläche erzielen. Mit metallischen Beschichtungen und insbesondere Beschichtungen aus Gold oder Gold-Legierungen lässt sich auf einfache Weise eine lichtundurchlässige und/ oder reflektierende Beschichtung erzielen, insbesondere bei Schichtdicken von einigen 100 nm. Als besonders vorteilhaft hat sich eine Chrom-Gold-Legierung zur Beschichtung der Lichtaustrittsfläche erwiesen. Mit einer Chrom-Gold-Beschichtung kann die Lichtausbeute der LED-Lichtquelle durch Mehrfachreflexionen auf besonders einfache Art und Weise gesteigert werden.

In einer weiteren Ausführungsform der Erfindung wird mindestens eine umfängliche Teilfläche der LED-Lichtquelle beschichtet. Zur Beschichtung der umfänglichen Teilfläche kann die gleiche oder eine andere Beschichtung, wie sie zur Beschichtung der Lichtaustrittsfläche verwendet wird, genutzt werden. Insbesondere kann die umfängliche Teilfläche mit mehreren Beschichtungen und/oder mehrlagig beschichtet werden. Durch die Beschichtung der umfänglichen Teilfläche, welche je nach Form der LED-Lichtquelle im Wesentlichen quer zur Lichtaustrittsfläche verläuft, kann ein nicht durch das Lichtaustrittsfenster verlaufender Lichtweg aus der LED-Lichtquelle unterbunden werden. Auf diese Weise kann erreicht werden, dass ein unerwünschtes Streulicht nicht auf einen benachbarten Lichtsensor fällt und zur Verfälschung eines Ausgangssignals führt. Die beschichtete umfängliche Teilfläche kann alternativ oder zusätzlich zur Reflexion eines Lichtstrahls in Richtung des Inneren der LED-Lichtquelle dienen, um durch Mehrfachreflexionen die Lichtausbeute der LED-Lichtquelle zu erhöhen.

Weiter vorteilhaft ist es, wenn vier umfängliche Teilflächen, insbesondere sämtliche umfängliche Teilflächen, der LED-Lichtquelle beschichtet werden. Die Beschichtung der einzelnen umfänglichen Teilflächen können sich voneinander unterscheiden oder identisch zueinander ausgeführt werden. Insbesondere können die umfänglichen Teilflächen zeitgleich beschichtet werden.

Ferner kann es vorteilhaft sein, wenn die mindestens eine umfängliche Teilfläche der LED-Lichtquelle und die Lichtaustrittsfläche nacheinander beschichtet werden. Zuerst kann die umfängliche Teilfläche und hieran anschließend die Lichtaustrittsfläche beschichtet werden. Gleichwohl kann auch zuerst die Lichtaustrittsfläche und hieran anschließend die umfängliche Teilfläche beschichtet werden. Bei einer nacheinander erfolgenden Beschichtung der umfänglichen Teilfläche und der Lichtaustrittsfläche können insbesondere unterschiedliche Beschichtungen auf die mindestens eine umfängliche Teilfläche und die Lichtaustrittsfläche aufgebracht werden.

Weiter vorteilhaft ist es, wenn die Lichtaustrittsfläche mit einer anderen Beschichtung als die mindestens eine umfängliche Teilfläche der LED-Lichtquelle beschichtet wird. Da die umfängliche Teilfläche im Mold-Gehäuse eingemoldet ist und mit diesem in Kontakt steht, während die Lichtaustrittsfläche nach außen freiliegt, kann durch die zueinander unterschiedlichen Beschichtungen der mindestens einen umfänglichen Teilfläche und der Lichtaustrittsfläche dieser unterschiedlichen Anordnung der einzelnen Flächen im optoelektronischen Bauelement Rechnung getragen werden. Die Beschichtung der Lichtaustrittsfläche kann derart ausgebildet sein, dass sie möglichst lichtundurchlässig ist, so dass bis auf das durch das Lichtaustrittsfenster austretende Licht kein weiteres Licht über die im Mold-Gehäuse nach außen freiliegende Lichtaustrittsfläche aus der LED-Lichtquelle austritt. Die Beschichtung der umfänglichen Teilfläche kann hingegen in erster Linie reflektierend ausgebildet sein, so dass die gesamte Lichtausbeute der LED-Lichtquelle erhöht werden kann. Die Lichtundurchlässigkeit der umfänglichen Teilfläche kann im Vergleich hierzu zurückstehen, da die umfängliche Teilfläche an dem Mold-Gehäuse anliegt, so dass auch das Mold-Material zur Reduzierung unerwünschten Streulichts zusätzlich zur Beschichtung der umfänglichen Teilfläche beiträgt.

Gemäß einer weiteren Ausführungsform der Erfindung wird vorgeschlagen, dass die Lichtaustrittsfläche durch physikalische Gasphasenabscheidung, insbesondere durch Sputtern, beschichtet wird. Durch physikalische Gasphasenabscheidung kann die Lichtaustrittsfläche auf einfache Weise mit einer, insbesondere dünnen, Beschichtung beschichtet werden. Durch die physikalische Gasphasenabscheidung, insbesondere durch Sputtern, kann eine Beschichtung mit einer weitgehend homogenen und zuvor definierten Schichtdicke und/oder eine strukturierte Beschichtung erzielt werden. Eine chemische Reaktion mit der Lichtaustrittsfläche kann durch die physikalische Gasphasenabscheidung vermieden werden. Eine Veränderung der Oberflächenstruktur der Lichtaustrittsfläche, insbesondere im Bereich des Lichtaustrittsfensters, nach der bereichsweisen Entschichtung kann durch die Verwendung der physikalischen Gasphasenabscheidung zur Beschichtung vermieden werden.

Eine weitere Ausgestaltung sieht vor, dass die Lichtaustrittsfläche durch Ätzen, mechanische Bearbeitung und/oder Lasern entschichtet wird. Eine bereichsweise Entschichtung der Lichtaustrittsfläche durch Ätzen, mechanische Bearbeitung und/oder Laser kann zur vollflächigen Entschichtung des das Lichtaustrittsfenster bildenden Teils der Lichtaustrittsfläche genutzt werden. Alternativ können die Entschichtungsverfahren zur Vergrößerung eines unbeschichteten Teils des Lichtaustrittsfensters genutzt werden, insbesondere zur Erzielung scharfer, das Lichtaustrittsfenster begrenzender Ränder im Übergang zu den beschichteten Bereichen der Lichtaustrittsfläche. Das Ätzen, die mechanische Bearbeitung und/oder das Lasern können zur bereichsweisen Entschichtung der beschichteten Lichtaustrittsfläche, bei einer bereits in das Mold-Gehäuse eingemoldeten LED-Lichtquelle genutzt werden. Bei der Entschichtung durch Ätzen und/oder Lasern können photolithografische Verfahren genutzt werden, mit welchen die Abmessungen und die Geometrie des Lichtaustrittsfensters auf einfache Weise vorgegeben werden können und die Lichtaustrittsfläche im Bereich des Lichtaustrittsfensters entschichtet werden kann. Ein Entschichten der Lichtaustrittsfläche durch Laser ermöglicht es, ein oder mehrere kleinflächige Lichtaustrittsfenster bereitzustellen, mit welchen die Auflösung des optoelektronischen Bauelements gesteigert werden kann. Vorzugsweise lassen sich durch Lasern Lichtaustrittsfenster mit einer Breite im Bereich von 50 µm und weniger, insbesondere mit einer Schlitzbreite von 20 µm und weniger, erzielen. Zur Entschichtung durch mechanische Bearbeitung kann die beschichtete Lichtaustrittsfläche abtragend bearbeitet werden, insbesondere durch ein Schleifen oder Ansägen.

Bevorzugt wird die Lichtaustrittsfläche zur Bereitstellung des Lichtaustrittsfensters rechteckförmig, spaltförmig, ellipsenförmig und/oder kreisförmig entschichtet. Durch die rechteckförmige, spaltförmige, ellipsenförmige und/oder kreisförmige bereichsweise Entschichtung der Lichtaustrittsfläche kann die geometrische Form des Lichtaustrittsfensters an die Einsatzanforderungen des optoelektronischen Bauelements individuell angepasst werden. Die rechteckförmigen, spaltförmigen, ellipsenförmigen und/oder kreisförmigen Entschichtungen können zur Erzielung eines Lichtaustrittsfensters komplexerer Geometrie miteinander kombiniert werden. Durch eine Kombination lassen sich unterschiedliche Formen des Lichtaustrittsfensters auf einfache Weise erzielen.

In einer weiteren Ausgestaltung der Erfindung wird die Lichtaustrittsfläche vor oder nach dem Molding beschichtet. Eine Beschichtung der Lichtaustrittsfläche vor dem Molding ermöglicht eine Beschichtung, welche die Lichtaustrittsfläche mit einem Überlapp auf umfängliche Teilflächen bedeckt. Ein solcher Überlapp kann bei ebenfalls erfolgender Beschichtung einer oder mehrerer umfänglicher Teilflächen, insbesondere mit der gleichen Beschichtung, wie sie zur Beschichtung der Lichtaustrittsfläche genutzt wird, von Vorteil sein. Die LED-Lichtquelle kann auf diese Weise, insbesondere im bekannten Bereich, zwischen der Lichtaustrittsfläche und den umfänglichen Teilflächen bedeckt werden. Durch eine nach dem Molding erfolgende Beschichtung der Lichtaustrittsfläche können die Schritte zur Bereitstellung des Lichtaustrittsfensters gemeinsam nach dem Molding erfolgen.

Eine weitere Ausgestaltung sieht vor, dass die Lichtaustrittsfläche vor oder nach dem Molding bereichsweise entschichtet wird. Bei einer Entschichtung vor dem Molding kann die Bereitstellung des Lichtaustrittsfensters noch vor dem Moldingprozess erfolgen. Durch eine Entschichtung der Lichtaustrittsfläche nach dem Molding kann die Bereitstellung des Lichtaustrittsfensters an einer im Mold-Gehäuse positionsfest angeordneten LED-Lichtquelle erfolgen. Die Lage und Orientierung des Lichtaustrittsfensters der LED-Lichtquelle kann bei einer nach dem Molding erfolgenden Entschichtung an einer in Relation zum Mold-Gehäuse oder zu einem im Mold-Gehäuse angeordneten Lichtsensor vorgebbaren Position erfolgen. Durch die Entschichtung nach dem Molding wird eine reproduzierbare Herstellung von optoelektronischen Bauelementen mit identischen Abstrahleigenschaften ermöglicht. Auswirkungen auf die Position und/oder Lage des Lichtaustrittsfensters relativ zum Mold-Gehäuse oder zum Lichtsensor aufgrund von Unterschieden zwischen einzelnen LED-Lichtquellen und ggf. beim Molding auftretenden Positionsvariationen der LED-Lichtquelle gegenüber dem Mold-Gehäuse oder der LED-Lichtquelle gegenüber dem Lichtsensor können durch eine Entschichtung nach dem Molding vermieden werden.

In einer vorteilhaften Ausgestaltung der Erfindung kann die Beschichtung der Lichtaustrittsfläche und das bereichsweise Entschichten der Lichtaustrittsfläche beides vor dem Molding, die Beschichtung der Lichtaustrittsfläche vor dem Molding und die bereichsweise Entschichtung nach dem Molding oder die Beschichtung der Lichtaustrittsfläche und die bereichsweise Entschichtung der Lichtaustrittsfläche beides nach dem Molding erfolgen.

Bei einem optischen Positionsencoder der eingangs genannten Art wird zur Lösung der vorstehenden Aufgabe vorgeschlagen, dass die Lichtaustrittsfläche beschichtet ist und ein entschichtetes Lichtaustrittsfenster aufweist.

Da die LED-Lichtquelle, bei welcher es sich insbesondere um einen Halbleiter-LED-Chip handelt, selbst beschichtet ist, kann diese weiterhin nach außen freiliegen. Unerwünschte Brechungen der Lichtstrahlen an den Übergängen zwischen der LED-Lichtquelle und einem Abdeckelement, wie einer Glasplatte, sowie die zwischen dem Abdeckelement und der Umgebung sind vermeidbar. Die LED-Lichtquelle kann durch die beschichtete Lichtaustrittsfläche und das entschichtete Lichtaustrittsfenster mit einer integralen Maskierung ausgestattet sein. Da die Auflösung des optoelektronischen Bauelements durch die Beschichtung der Lichtaustrittsfläche und die Entschichtung des Lichtaustrittsfensters nicht mehr von dem Herstellungsverfahren und den Fertigungstoleranzen bei der Herstellung der unterschiedlichen LED-Lichtquellen, insbesondere eines Halbleiterkristalls des Halbleiter-LED-Chips, und nicht mehr von der Justage der LED-Lichtquelle zu einem Lichtsensor, sondern von der Beschichtung und der Entschichtung sowie den Abmessungen des Lichtaustrittsfensters abhängt, können bessere Abstrahleigenschaften und insbesondere bessere Signalqualitäten sowie höhere Auflösungen erzielbar sein. Die Toleranzen bei der Beschichtung und der Entschichtung können deutlich geringer als die Fertigungstoleranzen sein.

Das entschichtete Lichtaustrittsfenster kann präziser fertigbar sein und insbesondere scharfe Ränder und damit verbesserte Abstrahleigenschaften aufweisen.

Die im Zusammenhang mit dem erfindungsgemäßen Verfahren beschriebenen Merkmale können einzeln oder in Kombination auch bei dem optischen Positionsencoder zur Anwendung kommen. Es ergeben sich die gleichen Vorteile, welche bereits beschrieben wurden.

Gemäß einer konstruktiven Ausgestaltung wird vorgeschlagen, dass die Lichtaustrittsfläche eine im Wesentlichen lichtundurchlässige und/oder reflektierende Beschichtung aufweist. Die Beschichtung kann sich dabei nicht nur über die Lichtaustrittsfläche erstrecken, sondern auch zusätzlich die umfänglichen Teilflächen der LED-Lichtquelle, insbesondere die LED-Lichtquelle, vollumfänglich bedecken. In vorteilhafter Weise kann sich die Beschichtung über sämtliche Seiten der LED-Lichtquelle mit Ausnahme der Kontaktseite zur elektrischen Kontaktierung der LED-Lichtquelle erstrecken, insbesondere diese Seiten dabei vollflächig bedecken. Die Kontaktseite der LED-Lichtquelle kann der Lichtaustrittsfläche diametral gegenüberliegen, so dass die LED-Lichtquelle nach Art einer sogenannten Flip-Chip-LED ausgebildet sein kann. Durch die, insbesondere reflektierende, Beschichtung der umfänglichen Teilflächen kann eine Mehrfachreflexion im Inneren der LED-Lichtquelle erzielbar sein. Die Lichtausbeute der LED-Lichtquelle, d. h. die Intensität des durch das Lichtaustrittsfenster aus der LED-Lichtquelle austretenden Lichts, kann gesteigert werden. Die Beschichtung kann mehrschichtig und insbesondere mehrlagig sein.

Ferner kann es vorteilhaft sein, wenn die Beschichtung eine Schichtdicke von unter 600 nm, insbesondere unter 400 nm, aufweist. Durch eine Schichtdicke von unter 600 nm und insbesondere unterhalb 400 nm kann das optoelektronische Bauelement materialsparend ausgestaltet sein. Auf diese Weise lassen sich Gewicht und Kosten einsparen.

Bei einer vorteilhaften Ausgestaltung ist eine von der Lichtaustrittsfläche abgewandte Seite der LED-Lichtquelle eine Kontaktseite der LED-Lichtquelle. Bei der von der Lichtaustrittsfläche abgewandten Seite der LED-Lichtquelle kann es sich um die diametral zur Lichtaustrittsfläche gegenüberliegenden Seite der LED-Lichtquelle handeln. Durch die Kontaktseite kann das optoelektronische Bauelement mit einer LED-Lichtquelle nach Art eines Flip-Chips ausgestattet sein. Auf Kontaktdrähte und elektrisch leitende Kanäle zur elektronischen Kontaktierung der Lichtaustrittsfläche kann durch die Flip-Chip-Geometrie verzichtet werden. Abschattungen durch Kontaktdrähte können vermieden werden. Die gesamte Lichtaustrittsfläche kann zur Bereitstellung eines Lichtaustrittsfensters nutzbar sein.

Zur Vermeidung einer Kurzschlussgefahr kann die Kontaktseite vorteilhafterweise unbeschichtet ausgebildet sein. Die Beschichtung der Lichtaustrittsfläche und/oder die Beschichtung einer der umfänglichen Teilflächen können sich insbesondere nicht bis auf die Kontaktseite der LED-Lichtquelle erstrecken. Die LED-Lichtquelle kann in vorteilhafter Weise ausschließlich über die Kontaktseite elektrisch kontaktierbar sein.

Vorzugsweise ist die Moldmasse des Mold-Gehäuses, insbesondere im Wellenlängenbereich der LED-Lichtquelle, intransparent. Durch ein Mold-Gehäuse aus einer intransparenten Moldmasse können unerwünschte Lichteffekte, wie Streulicht oder dergleichen, unterbunden werden. Die Mold-masse kann insbesondere opak sein, d. h. nicht transluzent, so dass kein Licht durch das Mold-Gehäuse hindurchtreten oder aus diesem mit Ausnahme der Lichtaustrittsfläche der LED-Lichtquelle austreten kann. Es ist möglich, aber nicht erforderlich, ein zusätzliches Trennelement zur Unterbindung von Fremdlichteinfällen auf das Mold-Gehäuse und/oder die LED-Lichtquelle vorzusehen. Bevorzugt weist die Moldmasse einen niedrigen thermischen Ausdehnungskoeffizienten auf, so dass keine Temperatureinschränkungen gegeben sind. Durch die intransparente und insbesondere opake Moldmasse können negative Effekte verringert werden, wie Streuungen oder Reflexionen durch ein Verkratzen der Oberfläche des Mold-Gehäuses. Darüber hinaus ergibt sich der Vorteil, dass auf Standardmaterialien zurückgegriffen werden kann, wodurch eine Reduzierung der Herstellungskosten erzielbar ist. Bei der Moldmasse kann es sich dabei insbesondere um ein Epoxidharz handeln.

Eine bevorzugte Ausgestaltung sieht vor, dass in dem Mold-Gehäuse mindestens ein Lichtsensor angeordnet ist. Über den Lichtsensor kann ein insbesondere an einer Maßverkörperung reflektiertes und moduliertes Licht detektiert werden. Der Lichtsensor kann hierzu fotosensitive optoelektronische Flächen aufweisen und die empfangenen Signale in Form von elektrischen Ausgangssignalen zur Verfügung stellen. Der Lichtsensor kann bevorzugt mehrere Teilflächen und/oder weitere Schaltungselemente umfassen. Die Teilflächen des Lichtsensors können symmetrisch zueinander angeordnet sein. Auch können mehrere Teilflächen zu Gruppen zusammengefasst sein. Die Teilflächen können spiegelsymmetrisch zueinander angeordnet sein, wobei bei einem Rotationsencoder die Symmetrien der Sensorflächen für eine Rotationsanordnung zu berücksichtigen sind. Die einzelnen Sensorflächen können periodisch miteinander elektrisch verbunden sein.

In Weiterbildung der Erfindung ist der direkte Lichtweg zwischen der LED-Lichtquelle und dem Lichtsensor, insbesondere durch das Mold-Gehäuse, unterbunden. Auf diese Weise kann erreicht werden, dass unerwünschtes Streulicht nicht auf die Sensorflächen des Lichtsensors fällt und zu einer Verfälschung des Ausgangssignals führt. Die Unterbindung des Lichtwegs kann durch eine Beschichtung der dem Lichtsensor zugewandten umfänglichen Teilfläche der LED-Lichtquelle und/oder durch das intransparente, insbesondere opake, Mold-Gehäuse erreicht werden. Die Moldmasse kann hierzu zwischen den einzelnen Elementen angeordnet sein, wie zwischen der LED-Lichtquelle und dem Lichtsensor. Die Verwendung eines zusätzlichen, insbesondere intransparenten und/oder opaken optischen Trennelements ist möglich, aber nicht erforderlich. Im Falle eines Trennelements kann dieses zwischen der LED-Lichtquelle und dem Lichtsensor angeordnet sein und beispielsweise als Steg, Wall, Trennwand oder dergleichen, ausgebildet sein.

Bevorzugt ist, wenn das Mold-Gehäuse im Bereich des Lichtsensors eine Ausnehmung aufweist, über welche das modulierte Licht zum Lichtsensor gelangen kann. Die Ausnehmung kann durch ein oberhalb des Lichtsensors angeordnetes transparentes Zusatzelement gebildet werden, wie etwa eine Platte aus Glas, Plastik oder einen transparenten Harz. Das Zusatzelement kann bündig mit der Außenseite des Mold-Gehäuses abschließen, wodurch sich ein ebener Verlauf der Außenseite des Gehäuses ergibt. Das Zusatzelement kann derart ausgebildet sein, dass das modulierte Licht nur auf bestimmte Bereiche des Sensors treffen kann. Hierzu kann das Zusatzelement als Maskierungsaufsatz ausgebildet sein. Das als Maskierungsaufsatz ausgebildete Zusatzelement kann beispielsweise aus einem lichtundurchlässigen Material gefertigt sein und lichtdurchlässige, insbesondere transparente, Ausnehmungen aufweisen oder aus einem lichtdurchlässigen, insbesondere transparenten, Material gefertigt sein, auf welches eine lichtundurchlässige Beschichtung aufgebracht werden kann. Alternativ oder zusätzlich kann das Zusatzelement als Schutzelement dienen, um insbesondere dem Lichtsensor vor Beschädigungen schützen zu können.

Gemäß einer konstruktiven Ausgestaltung wird vorgeschlagen, dass ein zum Schutz oberhalb des Lichtsensors angeordnetes Zusatzelement die gleiche Höhe wie die LED-Lichtquelle aufweist. Das insbesondere oberhalb des Lichtsensors angeordnete Zusatzelement kann ebenfalls bündig mit der Oberseite des Mold-Gehäuses abschließen, so dass sich eine ebene Außenfläche in die Abstrahlrichtung des optoelektronischen Bauelements ergibt. Das Zusatzelement kann zusammen mit der LED-Lichtquelle auf einem Träger angeordnet sein. Hierdurch ergeben sich insbesondere Vorteile in der Herstellung des optoelektronischen Bauelements und insbesondere bei der Positionierung der LED-Lichtquelle und des Zusatzelements im Spritzgusswerkzeug vor dem Molding.

Darüber hinaus ist eine Ausgestaltung vorteilhaft, bei welcher mehrere LED-Lichtquellen und/oder mehrere Lichtsensoren vorgesehen sind. Durch das Vorsehen mehrerer LED-Lichtquellen und/oder Lichtsensoren können in einem optoelektronischen Bauelement mehrere Codespuren realisierbar sein, mittels welcher, insbesondere zusammenwirkend mit mehreren Maßverkörperungen, mehr Positionsinformationen gewonnen und ausgewertet werden können.

Gemäß einer weiteren konstruktiven Ausgestaltung ist die LED-Lichtquelle und/oder der Lichtsensor auf einem Träger angeordnet. Bei dem Träger kann es sich bevorzugt um einen aus einem Halbleitersubstrat ausgebildeten Chip handeln. Alternativ kann der Träger ein Leadframe, ein Sockel oder ein anderes Element zur Positionsfestlegung sein. Bei einem als Chip ausgebildeten Träger kann dieser wiederum auf einem Leadframe, wie einem lötbaren metallischen Leitungsträger in Form eines Rahmens oder einem isolierenden Träger, angeordnet sein. Bevorzugt ist die LED-Lichtquelle und/oder der Lichtsensor erhöht angeordnet, wodurch sich auf einfache Weise die Möglichkeit ergibt, dass die LED-Lichtquelle und/oder der Lichtsensor zumindest mit einer Teilfläche nach außen freiliegt und/oder mit dem Mold-Gehäuse bündig abschließt.

Vorzugsweise ist die LED-Lichtquelle auf einem dem Lichtsensor und/oder einer Signalverarbeitungseinheit umfassenden Träger angeordnet. Der Träger kann als Chip aus einem Halbleitersubstrat ausgebildet sein. Der Chip kann als Signalverarbeitungseinheit die vom Lichtsensor erfassten und als elektrische Ausgangssignale zur Verfügung gestellten Positionsinformationen auswerten. Alternativ oder zusätzlich kann der Lichtsensor und/oder die Signalverarbeitungseinheit in dem Chip integriert sein. Die LED-Lichtquelle kann als Chip-on-Chip-Aufbau auf den als Chip ausgebildeten Träger anordbar sein.

Eine vorteilhafte Ausgestaltung sieht eine Signalverarbeitungseinheit für die LED-Lichtquelle und/oder den Lichtsensor vor. Mittels der Signalverarbeitungseinheit können die vom Lichtsensor detektierten Signale verarbeitet, die LED-Lichtquelle angesteuert und/oder weitere Signalverarbeitungsprozesse durchgeführt werden. Die Signalverarbeitungseinheit kann eine integrierte Schaltung, insbesondere eines als Halbleiter-Chip ausgebildeten Trägers, sein. Der LED-Lichtquelle und dem Lichtsensor kann jeweils eine Signalverarbeitungseinheit zugeordnet sein, welche insbesondere miteinander oder mit einer Steuereinheit zum Datenaustausch verbunden sein können.

Vorzugsweise ist die LED-Lichtquelle derart ausgebildet, dass sie Licht mit einer Wellenlänge von weniger als 700 nm, insbesondere weniger als 500 nm, aussendet. Durch die Verwendung Lichts dieses Wellenlängenbereichs können feinere Strukturen, insbesondere einer Maßverkörperung, erfassbar sein. Das von der LED-Lichtquelle ausgesendete Licht kann im Wellenlängenbereich des sichtbaren Lichts oder darunter liegen. Bevorzugt sendet die LED-Lichtquelle grünes, blaues oder ultraviolettes Licht aus. Durch die Verwendung von Licht mit einer Wellenlänge von weniger als 500 nm können die Lichtsensoren kleinere Abmessungen oder spitze Bereiche, wie Spitzecken oder Spitzeinkerbungen, auflösen. Bevorzugt beträgt die Wellenlänge des ausgesendeten Lichts weniger als 480 nm, ferner kann die Wellenlänge des ausgesendeten Lichts größer als 400 nm, bevorzugt größer als 425 nm, und besonders bevorzugt größer als 450 nm, sein. Darüber hinaus ergibt sich bei der Verwendung einer blauen oder noch kurzwelligeren LED-Lichtquelle der Vorteil, dass härtere Halbleitermaterialien als bei anderen LED-Lichtquellen verwendet werden können, welche weniger anfällig für ein Verkratzen sind und zudem höheren Drücken während des Herstellungsprozesses, insbesondere während des Moldings, standhalten können.

Bei einer kreisförmigen Maßverkörperung mit einer Codespur von 26 mm Durchmesser kann mit Hilfe des erfindungsgemäßen optoelektronischen Bauelements bei 1.000 Pulsen eine Strichbreite von 37 µm auf der Maßverkörperung, statt der bislang möglichen 60 µm, auflösbar sein.

Bei einer vorteilhaften Ausgestaltung ist die Maßverkörperung partiell reflexiv und kodiert ausgebildet. Durch eine reflexive Ausbildung der Maßverkörperung können die LED-Lichtquelle und ein Lichtsensor in einem gemeinsamen optoelektronischen Bauelement angeordnet werden. Das von der LED-Lichtquelle durch das Lichtaustrittsfenster abgestrahlte Licht kann von der Maßverkörperung in Richtung des Lichtsensors reflektiert und von diesem erfasst werden. Die Maßverkörperung kann als absolut kodierte Maßverkörperung ausgebildet sein, durch welche für jede auflösbare Position ein eindeutiger Positionswert bestimmbar ist. Auf die Durchführung einer Referenzierung zu Beginn einer Messung kann verzichtet werden, wobei diese gleichwohl durchgeführt werden kann.

In einer vorteilhaften Ausgestaltung der Erfindung sind mehrere Lichtsensoren zur Bestimmung einer Absolutposition vorgesehen. Durch das Vorhandensein mehrerer Lichtsensoren können mehrere Codespuren der Maßverkörperung abgetastet und genauere Positionsdaten erfasst werden. Eine oder mehrere LED-Lichtquellen können für mehrere Lichtsensoren, Lichtsensorgruppen und/oder mehrere Codespuren der Maßverkörperung vorgesehen sein. Jeder Codespur der Maßverkörperung kann eine Gruppe von Teilflächen zugeordnet sein. Die LED-Lichtquellen können zwischen den Lichtsensoren, insbesondere mittig zwischen den Lichtsensoren oder symmetrisch zu einer Sensorachse, angeordnet sein. Auf diese Weise kann eine genauere Positionserfassung durchgeführt werden. Vorzugsweise weist der optische Positionsencoder mindestens zwei Lichtsensoren zur absoluten Positionserfassung auf.

Weitere Einzelheiten und Vorteile der Erfindung sollen nachfolgend anhand der in den Figuren dargestellten Ausführungsbeispielen der Erfindung exemplarisch erläutert werden. Darin zeigt:
- Fig. 1a: ein erstes Ausführungsbeispiel eines optischen Positionsencoders in einer schematischen Schnittdarstellung,
- Fig. 1b: ein zweites Ausführungsbeispiel eines optischen Positionsencoders in einer schematischen Schnittdarstellung,
- Fig. 2a: der optische Positionsencoder gemäß Fig. 1a in einer schematischen Perspektive,
- Fig. 2b: der optische Positionsencoder gemäß Fig. 1b in einer schematischen Perspektive,
- Fig. 3: einen Bereich eines erfindungsgemäßen optoelektronischen Bauelements im Bereich einer LED-Lichtquelle,
- Fig. 4: eine LED-Lichtquelle in einer schematischen Perspektive als Ausgangspunkt für das erfindungsgemäße Verfahren,
- Fig. 5: eine LED-Lichtquelle mit einer beschichteten Lichtaustrittsfläche in einer schematischen Schnittdarstellung und
- Fig. 6a bis 6c: drei Ausführungsbeispiele einer LED-Lichtquelle mit beschichteter Lichtaustrittsfläche und entschichtetem Austrittsfenster.

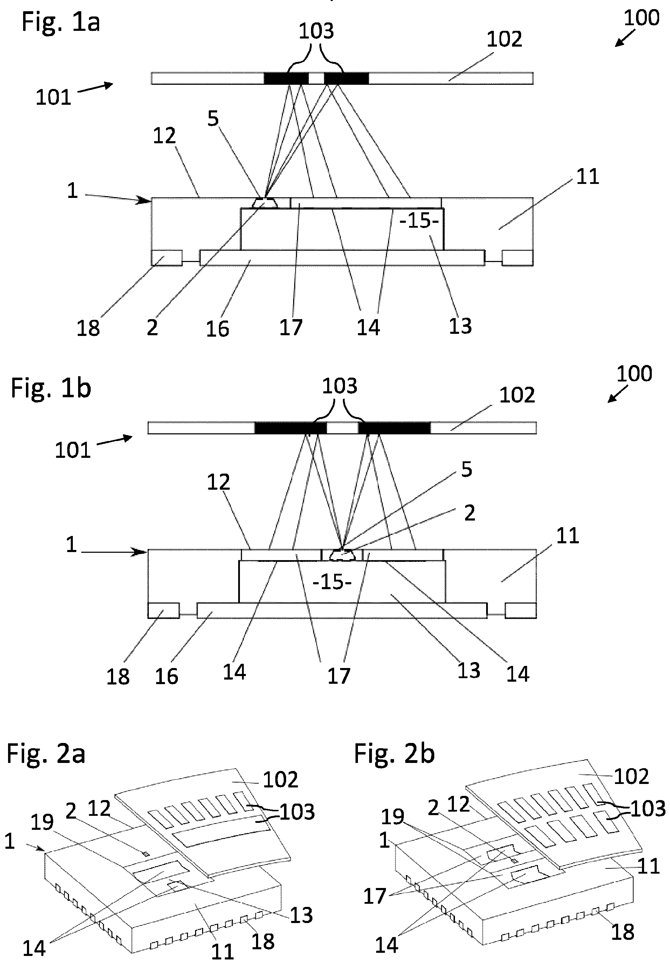

In den Fig. 1 und Fig. 2 sind zwei Ausführungsbeispiele eines erfindungsgemäßen optischen Positionsencoders 100 dargestellt. Diese Art von optischen Positionsencodern 100 wird vielfach in der Industrie verwendet, um die Position von Bauteilen erfassen zu können. Die Positionsencoder 100 können hierzu als linearer Positionsencoder oder aber auch als Rotationsencoder ausgebildet sein.

Um die Position eines Bauteils erfassen zu können, wird an dem Bauteil eine Maßverkörperung 101 angeordnet, welche unterschiedliche Bereiche 102, 103 aufweist. Bei den Bereichen 102, 103 kann es sich dabei um größtenteils absorbierende (hell dargestellt) und größtenteils reflektierende (dunkel dargestellt) Flächen handeln, welche auf sie treffendes Licht einer LED-Lichtquelle 2 entsprechend unterschiedlich verwerten. Die Bereiche 103 bilden jeweils eine Codespur, in welcher sich bei einer Bewegung der Maßverkörperung 101 senkrecht zur Darstellungsebene reflektierenden und absorbierenden Felder abwechseln und damit das auf sie treffende Licht modulieren. Es können eine oder mehrere Codespuren 103 zur Erzeugung inkrementeller Signale oder von Indexsignalen vorgesehen sein, so dass eine relative oder auch absolute Positionsbestimmung ermöglicht wird. In dem ersten Ausführungsbeispiel gemäß Fig. 1a und Fig. 2a ist die Maßverkörperung 101 zweispurig ausgebildet und bewegt sich relativ und orthogonal zu einer die LED-Lichtquelle 2 und einen Lichtsensor 14 verbindenden Achse des optoelektronischen Bauelements 1.

In dem zweiten Ausführungsbeispiel gemäß Fig. 1b und Fig. 2b weist die Maßverkörperung 101 ebenfalls zwei durch die Bereiche 103 gebildeten Codespuren auf. Der optische Positionsencoder 101 dieses Ausführungsbeispiels ist ein Absolutencoder, bei welchem mehrere Codespuren auf der Maßverkörperung 101 abgetastet werden, welche z. B. einen Pseudo-Random-Code bilden. Als absolut kodiert werden Maßverkörperungen 101 bezeichnet, deren Bereiche 103 eine digitale binäre Codierung aufweisen, die für jede auflösbare Position eindeutig ist und die aus mehreren gleichzeitig detektierten Codestellen besteht. Absorbierende Felder der Maßverkörperung 101 können dabei logische Low-Signale und reflektierende Felder entsprechend logische High-Signale generieren.

Bei beiden Ausführungsbeispielen können jedoch auch diffus reflektierende oder diffraktiv ausgebildete Bereiche 102, 103 der Maßverkörperung 101 genutzt werden.

Um die Position des Bauteils mit der Maßverkörperung 101 detektieren zu können, weist der optische Positionsencoder 100 ein optoelektronisches Bauelement 1 auf, welches Licht in Richtung der Maßverkörperung 101 emittiert. Das optoelektronische Bauelement 1 weist hierzu eine LED-Lichtquelle auf, beispielsweise in Form eines LED-Chips.

Bei einem solchen LED-Chip als LED-Lichtquelle 2 handelt es sich um eine lichtemittierende Diode bestehend aus einem Halbleiterkristall 3 mit einem Sockelbereich 4. Der pn-Übergang der LED-Lichtquelle ist dabei derart angeordnet, dass das erzeugte Licht im Wesentlichen durch eine Lichtaustrittsfläche 5 in Abstrahlrichtung aus der LED-Lichtquelle austritt und so vom optoelektronischen Bauelement 1 in Richtung der Maßverkörperung 101 emittiert wird.

In dem optoelektronischen Bauelement 1 ist die LED-Lichtquelle 2 auf einen Träger 13 angeordnet, so dass die Lichtaustrittsfläche 5 nach außen freiliegt. Die Lichtaustrittsfläche 5 schließt dabei im Wesentlichen bündig mit einer Außenseite 12 eines Mold-Gehäuses 11 ab. Auf diese Weise ergibt sich eine glatte Oberfläche des optoelektronischen Bauelements 1 im Bereich der LED-Lichtquelle 2. Während des Herstellungsprozesses sowie der allgemeinen Handhabung bei Test und der Bestückung einer Leiterplatte mit dem optoelektronischen Bauelement 1 bringt diese im Wesentlichen glatte Oberfläche des optoelektronischen Bauelements 1 Vorteile mit sich. So kann ein während der Herstellung genutztes Spritzgusswerkzeug einfacher, insbesondere ohne Ausprägungen, ausgestaltet werden, da keine Strukturen zur Positionsfestlegung oder optischen Justage erforderlich sind. Zudem können für die Handhabung von oberflächenmontierbaren Standardbauelementen ausgebildete Führungen, Greifer sowie Sauger für Test- und Bestückungseinrichtungen verwendet werden.

Die Lichtaustrittsfläche 5 ist in den Ausführungsbeispielen eben ausgebildet. Durch ein Lichtaustrittsfenster 10 der Lichtaustrittsfläche 5, welches von einer Beschichtung 9 der Lichtaustrittsfläche 5 begrenzt wird, kann das Licht in einem Lichtstrahl ausgestrahlt werden, welcher kleiner als die gesamte Lichtaustrittsfläche 5 ist. Da die beschichtete Lichtaustrittsfläche 5 der LED-Lichtquelle 2 nach außen freiliegt, werden Beeinflussungen der Lichtstrahlen nach deren Austreten, beispielsweise durch weitere Teile des optoelektronischen Bauelements 1, verhindert. Insoweit kann sichergestellt werden, dass die Lichtstrahlen in geeigneter Weise auf die Maßverkörperung 101 treffen.

Dadurch, dass durch das Lichtaustrittsfenster 10 ein scharf begrenzter Lichtstrahl geringen Ausmaßes bereitgestellt werden kann, um zur Positionsbestimmung nach der Modulation durch die Maßverkörperung 101 durch den Lichtsensor 14 auf dem Träger 13 erfasst zu werden, kann bei dem Positionsencoder 100 eine Maßverkörperung 101 mit Codespuren 103 genutzt werden, deren die Codierung bildenden absorbierenden und reflektierenden Felder mit 37 µm deutlich geringere Abmessungen in Richtung der Bewegungsrichtung der Maßverkörperung 101 aufweisen als herkömmliche Maßverkörperungen. Durch die Felder der Codespuren 103 mit geringeren Abmessungen, welche aufgrund der LED-Lichtquelle 2 mit einem Lichtaustrittsfenster 10 trotzdem noch aufgelöst werden können, wird eine genauere und höher aufgelöste Positionsbestimmung ermöglicht.

Ein möglicher Intensitätsverlust der Lichtstrahlen kann über eine Signalverarbeitungseinheit 15 nachregelt werden. Die Signalverarbeitungseinheit 15 ist in den dargestellten Ausführungsbeispielen Teil des Trägers 13, welcher nach Art eines die Signalverarbeitungseinheit 15 umfassenden Halbleiterchips ausgebildet ist. Neben der Signalverarbeitungseinheit 15 umfasst der Träger 13 auch die beiden Lichtsensoren 14, welche zusammen mit der LED-Lichtquelle 2 entlang einer gemeinsamen Achse angeordnet sind, wie in Fig. 2 gezeigt.

In den vorliegenden Ausführungsbeispielen ist der Träger 13 wiederum auf einem Leadframe 16 angeordnet.

Die LED-Lichtquelle 2 der Ausführungsbeispiele ist als LED mit einer Wellenlänge von 500 nm ausgebildet. Durch die Verwendung einer LED-Lichtquelle, welche Licht in diesem Wellenlängenbereich abstrahlt, lässt sich der Wirkungsgrad der Lichtsensoren 14 des optoelektronischen Bauelements 1 im Vergleich zur Verwendung Lichts größerer Wellenlänge steigern. So dringt das kurzwelligere Licht weniger tief in das Halbleitersubstrat der Lichtsensoren 14 ein, so dass ausreichend Ladungsträger in der Raumladungszone generiert und getrennt werden können, um den Wirkungsgrad der Lichtausbeute zu erhöhen. Außerdem führt Licht mit kürzerer Wellenlänge zu einer schärferen Abbildung von Strukturen der Codespuren 103 und damit zu höherer Auflösung des Positionsencoders 100.

Ein weiterer Vorteil von LED-Lichtquellen 2, die das Licht mit einer Wellenlänge von weniger als 700 nm und insbesondere weniger als 500 nm aussenden, besteht in den mechanischen Eigenschaften der verwendeten Materialien. Im Gegensatz zu anderen LED-Lichtquellen 2 sind diese härter ausgebildet, so dass sie dem beim Molding auftretenden Druck besser standhalten können. Eine geschützte Anordnung der LED-Lichtquelle 2 im Inneren des Mold-Gehäuses 11 ist daher nicht erforderlich. Vielmehr kann die LED-Lichtquelle 2 im direkten Kontakt mit einem nicht dargestellten Spritzgusswerkzeug beim Molding stehen. Die LED-Lichtquelle kann beispielsweise aus Carbid in Verbindung mit II-VI- oder III-V-Halbleitern bestehen.

Das von der LED-Lichtquelle 2 emittierte Licht wird in Richtung der Maßverkörperung 101 abgestrahlt und an dieser reflektiert. Aufgrund der sich abwechselnden Felder der Codespuren 103 wird das Licht entsprechend der Codierung der Maßverkörperung 101 moduliert. Das modulierte Licht wird in Richtung des ebenfalls in dem optoelektronischen Bauelement 1 angeordneten Lichtsensors 14 zurückgeworfen, welcher das modulierte Licht detektiert.

Der Lichtsensor 14 umfasst eine integrierte Schaltung und ist als Teil des als Halbleiterchips ausgebildeten Trägers 13 ausgestaltet. Der Lichtsensor 14 kann ferner lichtempfindliche, zu Gruppen zusammengefasste Teilflächen aufweisen, beispielsweise mehrere lichtempfindliche Fotodioden. Die Teilflächen können in Messrichtung liegen, d. h. quer zu einer sich zwischen dem Lichtsensor 14 und der LED-Lichtquelle 2 erstreckenden Achse, und mehrere Bits einer Codespur 103 erfassen oder verschachtelt hintereinander liegen und derart elektrisch miteinander verbunden sein, dass sich Sinus- und Cosinus-Signale ergeben, welche eine Phasenverschiebung aufweisen.

Oberhalb des Lichtsensors 14 ist als Zusatzelement 17 eine lichtdurchlässige Platte, insbesondere eine Glasplatte oder Kunststoffplatte, angeordnet. Dieses Zusatzelement 17 kann zum einen zum Schutz des Lichtsensors 14 und zum anderen als Maskierungsaufsatz dienen. Als Maskierungsaufsatz kann das Zusatzelement 17 Teilbereiche des Lichtsensors 14 abdecken, so dass das modulierte Licht nur auf bestimmte Bereiche des Lichtsensors 14 trifft.

Zur Aufnahme des Zusatzelements 17 weist das Mold-Gehäuse 11 im Ausführungsbeispiel der Fig. 1a und 2a eine einzelne Ausnehmung 19 auf. Das in dieser Ausnehmung 19 aufgenommene Zusatzelement 17 überdeckt beide Lichtsensoren 14.

Im Ausführungsbeispiel gemäß Fig. 1b und Fig. 2b weist das Mold-Gehäuse 11 zwei Ausnehmungen 19 auf, in welchen jeweils ein Zusatzelement 17 angeordnet werden kann. In diesem Ausführungsbeispiel überdeckt jedes Zusatzelement 17 einen eigenen ihm zugeordneten Lichtsensor 14. Das Zusatzelement 17 kann die gleiche Höhe wie die LED-Lichtquelle 2 aufweisen und bevorzugt im Bereich von 150 µm bis 140 µm liegen. Mit dem Zusatzelement 17 ergibt sich eine ebene Außenseite 12 des optoelektronischen Bauelements 1, obwohl das Mold-Gehäuse selbst eine oder mehrere Ausnehmungen 19 aufweist.

Das optoelektronische Bauelement 1 kann als SMD-Bauteil ausgebildet sein, welches über lötfähige Kontakte oder Drahtanschlüsse platzsparend auf eine Platine oder einem ähnlichen Trägerelement angeordnet werden kann. Zur Ermöglichung dieser Kontaktierung weist das Mold-Gehäuse 11 Anschlussflächen 18 auf, welche der LED-Lichtquelle 2 und dem Lichtsensor 14 gegenüberliegen. Über die Anschlussflächen 18 kann die Signalverarbeitungseinheit 15, mittels welcher Lichtsensordaten verarbeitet, die LED-Lichtquelle 2 geregelt und/oder sonstige Signalverarbeitungsprozesse durchgeführt werden können, in ein Datenaustauschnetz eingebunden werden, beispielsweise ein Regelsystem zur Regelung der Position des mit der Maßverkörperung 101 ausgestatteten Bauteils.

Neben der unterschiedlichen Anzahl von Ausnehmungen 19 des Mold-Gehäuses 11 unterscheiden sich die beiden Ausführungsbeispiele dahingehend, dass im Ausführungsbeispiel gemäß Fig. 1b und Fig. 2b die Lichtsensoren 14 beidseitig der LED-Lichtquelle 2 angeordnet sind. Die LED-Lichtquelle 2 befindet sich nicht an einer Seite eines Lichtsensors 14, wie dies im ersten Ausführungsbeispiel der Fall ist, sondern ist, insbesondere mittig, zwischen den Lichtsensoren 14 angeordnet. Die LED-Lichtquelle 2 ist hierzu in einem stegförmig ausgebildeten Teil des Mold-Gehäuses 11 zwischen den beiden Ausnehmungen 19 angeordnet. Ein gemäß diesem Ausführungsbeispiel ausgebildeter optischer Positionsencoder 100 eignet sich dabei insbesondere zur Realisierung eines die absolute Position angebenden absoluten Encoders. Ein erster Lichtsensor 14 kann dabei als Mastersensor und ein zweiter Lichtsensor 14 als Nonius-Sensor ausbildet sein. Alternativ kann ein erster Lichtsensor 14 eine Pseudo-Random-Spur und ein zweiter eine Inkrementalspur mit einem regelmäßigen Muster zur Interpolation und Erhöhung der Auflösung des Positionssensors erfassen. Auf diese Weisen kann die absolute Position des Bauteils über die Maßverkörperung 101 erfasst werden.

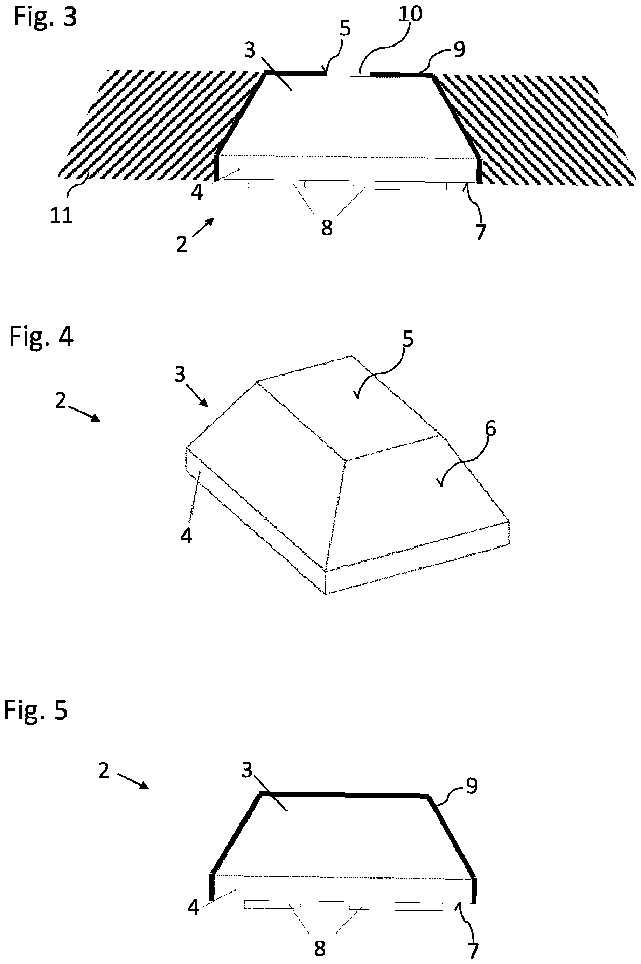

Fig. 3 zeigt einen Bereich des optoelektronischen Bauelements 1, in welchem die LED-Lichtquelle 2 in dem Mold-Gehäuse 11 angeordnet ist. Nicht zu erkennen sind die entgegen der Abstrahlrichtung unterhalb der LED-Lichtquelle 2 liegenden Komponenten des optoelektronischen Bauelements 1, insbesondere der Lichtsensor 14, der Träger 13 oder ein Leadframe 16, welche je nach Ausführungsform des optoelektronischen Bauelements 1 Teil desselben sein können. Zu erkennen ist der querschnittliche Aufbau der LED-Lichtquelle 2, bei welcher ein Halbleiterkristall 3 einen trapezförmigen Querschnitt und einen Sockelbereich 4 aufweist.

Der Lichtaustrittsfläche 5 der LED-Lichtquelle 2 entlang der Abstrahlrichtung der LED-Lichtquelle 2 diametral gegenüberliegend weist diese eine Kontaktfläche 7 auf. Die Kontaktfläche 7 dient zum einen der elektrischen Kontaktierung der LED-Lichtquelle 2, wozu an der Kontaktfläche 7 mindestens zwei Elektroden 8 angeordnet sind. Über die Kontaktfläche 7 und die Elektroden 8 kann ein elektrischer und/oder mechanischer Kontakt der LED-Lichtquelle 2 mit den übrigen in Fig. 3 nicht dargestellten Teilen des elektrooptischen Bauelements 1 und insbesondere mit dem Träger 13 hergestellt werden. Die LED-Lichtquelle 2 ist auf diese Weise nach Art eines Flip-Chips aufgebaut, dessen elektrische Kontaktierung nur von einer Seite über die Kontaktfläche 7 erfolgt.

Die Lichtaustrittsfläche 5, wie auch die umfänglichen Teilflächen 6 der LED-Lichtquelle 2, weisen eine Beschichtung 9 auf. Bei dieser Beschichtung 9 handelt es sich um eine mittels physischer Gasphasenabscheidung aufgebrachte Chrom-Gold-Legierung. Wenngleich die Beschichtung 9 in den Figuren zur besseren Darstellung mit einer breiten Linienführung dargestellt ist, so weist die Beschichtung 9 in der Realität lediglich eine Schichtdicke von 400 nm auf.

Die umfänglichen Teilflächen 6 der LED-Lichtquelle 2, welche zwischen der Lichtaustrittsfläche 5 und der Kontaktfläche 7 stehen und ebenfalls Licht emittieren können, sind vollflächig mit der Beschichtung 9 überzogen. Dabei erstreckt sich die Beschichtung 9 auch auf den ebenfalls Licht emittierenden Sockelbereich 4 des Halbleiterkristalls 3. Alternativ könnten eine oder mehrere der umfänglichen Teilflächen 6 auch unbeschichtet oder teilbeschichtet sein. Bei einer Teilbeschichtung würde sich die Beschichtung 9 nur auf einzelne Bereiche der umfänglichen Teilfläche 6 erstrecken, beispielsweise nur auf zum Sockelbereich 6 oder zum trapezförmigen Bereich gehörige Abschnitte der umfänglichen Teilfläche 6. Sowohl bei einem vollflächigen als auch bei einem teilflächigen Überzug einer oder mehrerer der umfänglichen Teilfläche 6 mit der Beschichtung 9 bleibt die Kontaktfläche 7 zumindest umfänglich der Elektroden 8 unbeschichtet. Damit werden ansonsten möglicherweise auftretende Kurzschlüsse zwischen den Elektroden 8 verhindert.

Umfänglich der LED-Lichtquelle 2 schließt sich das Mold-Gehäuse 11 direkt an die Beschichtung 9 der LED-Lichtquelle 2 an. Wenngleich das Mold-Gehäuse 11 selbst im Wellenlängenbereich der LED-Lichtquelle 2 intransparent ist, verhindert die lichtundurchlässige und/oder reflektierende Beschichtung 9 ein Austreten von Streulicht über die umfänglichen Teilflächen 6 und den beschichteten Bereich der Lichtaustrittsfläche 5. Da das Streulicht nicht aus der LED-Lichtquelle 2 austreten kann, kann dieses daher nicht bis zum Lichtsensor 14 gelangen und so auch nicht die Messungen zur Positionsbestimmung verfälschen.

Durch die reflektiven Eigenschaften der Beschichtung 9 wird das Streulicht zurück in das Innere der LED-Lichtquelle 2 reflektiert. Durch innere Reflexionen kann das Licht dabei solange im Inneren der LED-Lichtquelle 2 reflektiert werden, bis es über das entschichtete Lichtaustrittsfenster 10 der Lichtaustrittsfläche 5 austreten kann. Das reflektierte Streulicht tritt auf diese Weise zusammen mit dem direkt über das Lichtaustrittsfenster 10 austretende Licht, welches nicht zunächst innerhalb der LED-Lichtquelle 2 reflektiert wird, aus der LED-Lichtquelle 2 aus, so dass die Lichtausbeute der LED-Lichtquelle 2, d. h. die pro Flächeneinheit austretenden Photonen, im Vergleich zu einer nicht beschichteten LED-Lichtquelle 2 gesteigert wird.

Wenngleich im dargestellten Ausführungsbeispiel die Lichtaustrittsfläche 5 und die umfänglichen Teilflächen 6 die gleiche Beschichtung 9 aufweisen, so ist es durchaus möglich, dass die umfänglichen Teilflächen 6 unbeschichtet sind oder mit einer anderen Beschichtung 9 als die Lichtaustrittsfläche 5 versehen werden. So kann die Zusammensetzung und/oder die Schichtdicke der Beschichtung 9 einer der umfänglichen Teilflächen 6 oder mehrerer der umfänglichen Teilflächen 6 von der Beschichtung 9 der Lichtaustrittsfläche 5 abweichen. Gleichsam kann die Beschichtung 9 der Lichtaustrittsfläche 5 und/oder die Beschichtung 9 einer oder mehrerer der umfänglichen Teilflächen 6 aus mehreren Schichten bestehen.

Neben der Erhöhung der Lichtausbeute sowie der Möglichkeit, einen kleineren Lichtstrahl zur Verbesserung der Auflösung des gesamten optischen Positionsencoders 100 bereitzustellen, ermöglicht das entschichtete Lichtaustrittsfenster 10 einen Ausgleich von Fertigungstoleranzen des Halbleiterkristalls 3 der LED-Lichtquelle 2 sowie von Toleranzen bei der Positionierung der LED-Lichtquelle 2 in dem Spritzgusswerkzeug vor dem Molding. Wie dieser Ausgleich erzielt und ein entschichtetes Lichtaustrittsfenster 10 bereitgestellt wird, soll im Folgenden anhand der in den Figuren 4 bis 6 dargestellten Verfahrensschritten erläutert werden.

In Fig. 4 ist die zunächst unbeschichtete LED-Lichtquelle 2 dargestellt. Zu erkennen ist der Halbleiterkristall 3 mit seinem Sockelbereich 4. Die nicht gezeigte Kontaktfläche 7 weist als Grundfläche der LED-Lichtquelle 2 eine rechteckige Form auf und misst 240 µm x 320 µm. Der Halbleiterkristall 3, insbesondere oberhalb des Sockelbereichs 4, ist pyramidenstumpfförmig und weist an der zur Kontaktfläche 7 diametral gegenüberliegenden Seite die Lichtaustrittsfläche 5 auf. In Umfangsrichtung weist die LED-Lichtquelle 2 die im Wesentlichen quer zu der Lichtaustrittsfläche 5 und der Kontaktfläche 7 verlaufenden umfänglichen Teilflächen 6 auf.

Die bis dahin unbeschichtete LED-Lichtquelle 2 wird in einem ersten Verfahrensschritt mit der Beschichtung 9 versehen. Dieser Beschichtungsschritt kann entweder noch vor dem Molding und vor oder nach der Montage bzw. Fixierung der LED-Lichtquelle auf den Träger 13 erfolgen, was insbesondere vorteilhaft ist, wenn auch zumindest eine der umfänglichen Teilflächen 6 beschichtet werden soll. Denn nach dem Molding werden die Teilflächen 6 von der Moldmasse des Mold-Gehäuses 11 verdeckt und können auf diese Weise nicht mehr mit einer Beschichtung 9 versehen werden. Die Beschichtung 9 der Lichtaustrittsfläche 5 kann hingegen auch noch nach dem Molding aufgebracht werden oder ebenso wie die Beschichtung 9 der umfänglichen Teilflächen 6 vor dem Molding und vor oder nach der Montage bzw. Fixierung der LED-Lichtquelle auf dem Träger 13 erfolgen. Um eine möglichst gleichmäßige Beschichtung 9 zu erzielen, wird diese auf die unbeschichtete Lichtaustrittsfläche 5 aufgesputtert.

Nach dem Sputtern ist die Lichtaustrittsfläche 5, wie in Fig. 5 dargestellt, mit der Beschichtung 9 beschichtet. In dem dargestellten Zwischenschritt wurde die Lichtaustrittsfläche 5 vollflächig mit der Beschichtung 9 überzogen. Zur Vereinfachung und Beschleunigung des folgenden Verfahrensschritts ist es gleichwohl möglich, dass ein Bereich der Lichtaustrittsfläche 5, welcher später einen Teil des Lichtaustrittsfensters 10 bilden soll, unbeschichtet bleibt. Hierzu kann während des Sputterns ein Maskierungselement in den Sputterstrahl eingebracht oder vor dem Sputtern eine Maske auf die Lichtaustrittsfläche 5 aufgebracht werden. In beiden Fällen verhindert das Maskierungselement oder die Maske, dass sich das Material der Beschichtung 9 in einem abgedeckten Bereich auf der Lichtaustrittsfläche 5 abscheidet. Das Maskierungselement oder die Maske können in ihrer Form dem zu erzielenden Lichtaustrittsfenster 10 ähneln, jedoch im Vergleich zu diesem, geringere Abmessungen aufweisen.

Nach der Beschichtung der Lichtaustrittsfläche 5 wird ein Teilbereich der Lichtaustrittsfläche 5 zur Bereitstellung des Lichtaustrittsfensters 10 entschichtet. Diese Entschichtung kann noch vor dem Molding erfolgen. Dabei können Toleranzen in der relativen Positionierung der LED-Lichtquelle 2 zum Lichtsensor 14 auf dem gemeinsamen Träger 13 ausgeglichen werden. Um auch Toleranzen bei der Positionierung der LED-Lichtquelle 2 zum Spritzgusswerkzeug und/oder zu den äußeren Seiten und Rändern des optoelektronischen Bauelements 1 ausgleichen zu können, erfolgt die bereichsweise Entschichtung vorzugsweise nach dem Molding, insbesondere als letzter Schritt bei der Herstellung des optoelektronischen Bauelements 1. In diesem Fall kann sowohl eine bereits beschichtete LED-Lichtquelle 2 in das Mold-Gehäuse 11 eingemoldet werden oder die Beschichtung 9 erst nach dem Molding erfolgen.

Zur bereichsweisen Entschichtung der Lichtaustrittsfläche 5 und zur Bereitstellung des Lichtaustrittsfensters 10 wird die Beschichtung 9 in einzelnen Bereichen von der Lichtaustrittsfläche 5 wieder entfernt. Dieses Entfernen kann über eine mechanische Bearbeitung, ein chemisches Ätzen oder einen Laserbeschuss erfolgen. Insbesondere mittels eines Lasers lassen sich besonders präzise und scharfe Begrenzungen des Lichtaustrittsfensters 10 erzielen. Die Form und die Position des Lichtaustrittsfensters 10 können bei dem Entschichten an die jeweiligen Anforderungen des Sensors 14 und damit des optoelektronischen Bauelements 1 angepasst werden.

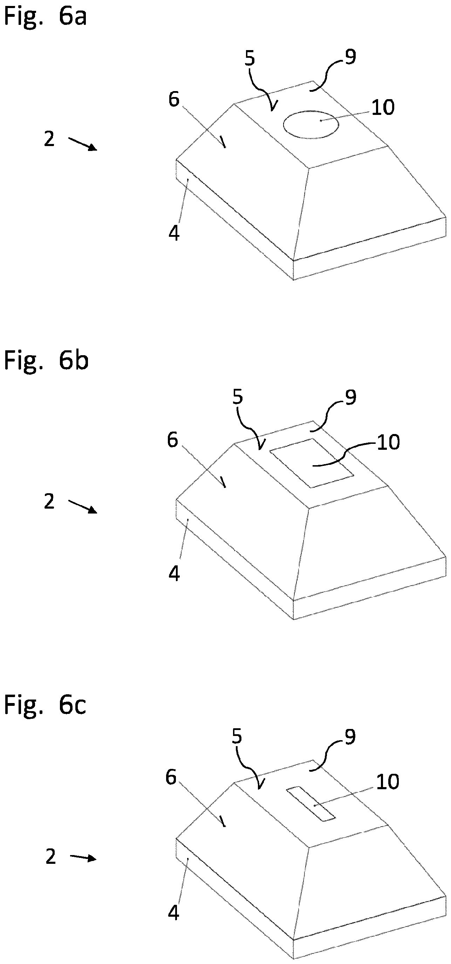

So kann durch ein kreisförmiges Entschichten das in Fig. 6a gezeigte kreisförmige Lichtaustrittsfenster erzielt werden. Das gezeigte kreisförmige Lichtaustrittsfenster 10 kann gleichwohl auch durch eine lineare Bearbeitung, wie beispielsweise ein Abrastern durch einen Laser, erzielt werden. Auch andere geometrische Formen des Lichtaustrittsfensters, wie beispielsweise das in Fig. 6b gezeigte rechteckförmige Lichtaustrittsfenster oder das in Fig. 6c gezeigte spaltförmige Lichtaustrittsfenster, lassen sich durch das Entschichten erzielen.

Insbesondere zur Erzielung eines spaltförmigen Lichtaustrittsfensters 10, wie dies in Fig. 6c gezeigt ist, hat sich die Verwendung eines Lasers zum Entschichten als vorteilhaft erwiesen, da sich hierdurch dünne Spalten mit einer Länge der kurzen Spaltseite von 20 µm erzielen lassen.

Neben den in Fig. 6 gezeigten einfachen geometrischen Formen können auch weitere geometrische Formen der Lichtaustrittsfenster 10 durch ein bereichsweises Entschichten der Lichtaustrittsfläche 5 erzielt werden, welche sich insbesondere aus geometrischen Grundformen, wie Rechtecken, Spalten, Ellipsen und Kreisen, zusammensetzen lassen.

Sofern bei der Beschichtung der Lichtaustrittsfläche 5 ein Maskierungselement oder eine Maske verwendet wurde, so dass ein zum Lichtaustrittsfenster 10 gehöriger Bereich der Lichtaustrittsfläche 5 nicht beschichtet wurde, so erfolgt die Entschichtung zur Bereitstellung des Lichtaustrittsfensters 10, insbesondere im Randbereich um diesen unbeschichteten Bereich, so dass durch die Entschichtungsverfahren, wie das Ätzen oder das Lasern, eine scharfe Begrenzung des Lichtaustrittsfensters 10 zwischen dem beschichteten und dem entschichteten Bereichen der Lichtaustrittsfläche 5 erzielt wird.

Mit Hilfe des vorstehend beschriebenen Verfahrens und des optischen Positionsencoders 100 ist es möglich, die Abstrahleigenschaften der LED-Lichtquelle 2 zu verbessern und die erzielbare Auflösung des optischen Positionsencoders 100 zu erhöhen.

### Bezugszeichen:

- 1: Optoelektronisches Bauelement
- 2: LED-Lichtquelle
- 3: Halbleiterkristall
- 4: Sockelbereich
- 5: Lichtaustrittsfläche
- 6: Teilfläche
- 7: Kontaktfläche
- 8: Elektroden
- 9: Beschichtung
- 10: Lichtaustrittsfenster
- 11: Mold-Gehäuse
- 12: Außenseite
- 13: Träger
- 14: Lichtsensor
- 15: Signalverarbeitungseinheit
- 16: Leadframe
- 17: Zusatzelement
- 18: Anschlussfläche
- 19: Ausnehmung

- 100: Optischer Positionsencoder
- 101: Maßverkörperung
- 102: Bereich außerhalb der Codespur
- 103: Bereich mit der Codespur

## Patentansprüche

1. Verfahren zur Herstellung eines optischen Positionsencoders (100) mit einem optoelektronischen Bauelement (1) und mit einer von einer LED-Lichtquelle (2) des optoelektronischen Bauelements (1) beleuchteten Maßverkörperung (101), bei welchem die LED-Lichtquelle (2) derart in ein Mold-Gehäuse (11) eingemoldet wird, dass eine Lichtaustrittsfläche (5) der LED-Lichtquelle (2) nach außen freiliegt, **dadurch gekennzeichnet,**
**dass** die Lichtaustrittsfläche (5) beschichtet wird und zur Bereitstellung eines Lichtaustrittsfensters (10) bereichsweise entschichtet wird.

2. Verfahren nach Anspruch 1, **dadurch gekennzeichnet, dass** die Lichtaustrittsfläche (5) vollflächig oder teilflächig mit einer, insbesondere im Wesentlichen lichtundurchlässigen und/oder reflektierenden, Beschichtung (9) beschichtet wird.

3. Verfahren nach einem der Ansprüche 1 oder 2, **dadurch gekennzeichnet, dass** die Lichtaustrittsfläche (5) mit einer metallischen Beschichtung (9) beschichtet wird, insbesondere mit einer Beschichtung (9) aus Gold oder aus einer Gold-Legierung.

4. Verfahren nach einem der vorhergehenden Ansprüche, **dadurch gekennzeichnet, dass** mindestens eine umfängliche Teilfläche (6) der LED-Lichtquelle (2) beschichtet wird.

5. Verfahren nach Anspruch 4, **dadurch gekennzeichnet, dass** die mindestens eine umfängliche Teilfläche (6) der LED-Lichtquelle (2) und die Lichtaustrittsfläche (5) nacheinander beschichtet werden.

6. Verfahren nach einem der Ansprüche 4 oder 5, **dadurch gekennzeichnet, dass** die Lichtaustrittsfläche (5) mit einer anderen Beschichtung (9) als die mindestens eine umfängliche Teilfläche (6) der LED-Lichtquelle (2) beschichtet wird.

7. Verfahren nach einem der vorhergehenden Ansprüche, **dadurch gekennzeichnet, dass** die Lichtaustrittsfläche (5) durch physikalische Gasphasenabscheidung, insbesondere durch Sputtern, beschichtet wird.

8. Verfahren nach einem der vorhergehenden Ansprüche, **dadurch gekennzeichnet, dass** die Lichtaustrittsfläche (5) durch Ätzen, mechanisch Bearbeitung und/oder Lasern entschichtet wird.

9. Verfahren nach einem der vorhergehenden Ansprüche, **dadurch gekennzeichnet, dass** die Lichtaustrittsfläche (5) vor oder nach dem Molding beschichtet wird.

10. Verfahren nach einem der vorhergehenden Ansprüche, **dadurch gekennzeichnet, dass** die Lichtaustrittsfläche (5) vor oder nach dem Molding bereichsweise entschichtet wird.

11. Optischer Positionsencoder mit einem optoelektronischen Bauelement (1) mit einem Mold-Gehäuse (11), in dem eine LED-Lichtquelle (2) derart angeordnet ist, dass ein Lichtaustrittsfenster (10) einer Lichtaustrittsfläche (5) der LED-Lichtquelle (2) nach außen freiliegt, und mit einer von der LED-Lichtquelle (2) des optoelektronischen Bauelements (1) beleuchteten Maßverkörperung (101),
**dadurch gekennzeichnet,**
**dass** die Lichtaustrittsfläche (5) teilweise mit einer Beschichtung (9) beschichtet ist, so dass das nach außen freiliegende Lichtaustrittsfenster (10) bereitgestellt ist.

12. Optischer Positionsencoder nach Anspruch 11, **dadurch gekennzeichnet, dass** eine von der Lichtaustrittsfläche (5) abgewandten Seite der LED-Lichtquelle (2) eine Kontaktseite (7) der LED-Lichtquelle (2) ist.

13. Optischer Positionsencoder nach einem der Ansprüche 11 oder 12, **dadurch gekennzeichnet, dass** in dem Mold-Gehäuse (11) mindestens ein Lichtsensor (14) angeordnet ist.

14. Optischer Positionsencoder nach einem der Ansprüche 11 bis 13, **dadurch gekennzeichnet, dass** die LED-Lichtquelle (2) und/oder der Lichtsensor (14) auf einem Träger (13) angeordnet ist.

15. Optischer Positionsencoder nach einem der Ansprüche 11 bis 14, **dadurch gekennzeichnet, dass** die LED-Lichtquelle (2) auf einem den Lichtsensor (14) und/oder eine Signalverarbeitungseinheit (15) umfassenden Träger (13) angeordnet ist.

## Claims

1. A method for producing an optical position encoder (100) having an optoelectronic component (1) and having a measuring scale (101) illuminated by an LED light source (2) of the optoelectronic component (1), in which the LED light source (2) is embedded into a molded housing (11) in such a way that a light exit surface (5) of the LED light source (2) is exposed to the outside,
**characterized in that**
the light exit surface (5) is coated and is de-coated in some regions to provide a light exit window (10).

2. The method as claimed in claim 1, **characterized in that** the light exit surface (5) is coated over the entire surface or part of the surface using a coating (9), which is in particular essentially light-opaque and/or reflective.

3. The method as claimed in one of claims 1 or 2, **characterized in that** the light exit surface (5) is coated using a metallic coating (9), in particular using a coating (9) made of gold or a gold alloy.

4. The method as claimed in any one of the preceding claims, **characterized in that** at least one peripheral partial surface (6) of the LED light source (2) is coated.

5. The method as claimed in claim 4, **characterized in that** the at least one peripheral partial surface (6) of the LED light source (2) and the light exit surface (5) are coated in succession.

6. The method as claimed in one of claims 4 or 5, **characterized in that** the light exit surface (5) is coated using a different coating (9) than the at least one peripheral partial surface (6) of the LED light source (2).

7. The method as claimed in any one of the preceding claims, **characterized in that** the light exit surface (5) is coated by physical gas phase deposition, in particular by sputtering.

8. The method as claimed in any one of the preceding claims, **characterized in that** the light exit surface (5) is de-coated by etching, mechanical processing, and/or lasering.

9. The method as claimed in any one of the preceding claims, **characterized in that** the light exit surface (5) is coated before or after the molding.

10. The method as claimed in any one of the preceding claims, **characterized in that** the light exit surface (5) is de-coated in some regions before or after the molding.

11. An optical position encoder having an optoelectronic component (1) having a molded housing (11) in which an LED light source (2) is arranged in such a way that a light exit window (10) of a light exit surface (5) of the LED light source (2) is exposed to the outside, and having a measuring scale (101) illuminated by the LED light source (2) of the optoelectronic component (1),
**characterized in that**
the light exit surface (5) is partially coated with a coating (9) so that the light exit window (10) exposed to the outside is provided.

12. The optical position encoder as claimed in claim 11, **characterized in that** a side of the LED light source (2) facing away from the light exit surface (5) is a contact side (7) of the LED light source (2).

13. The optical position encoder as claimed in one of claims 11 or 12, **characterized in that** at least one light sensor (14) is arranged in the molded housing (11).

14. The optical position encoder as claimed in any one of claims 11 to 13, **characterized in that** the LED light source (2) and/or the light sensor (14) is arranged on a carrier (13).

15. The optical position encoder as claimed in any one of claims 11 to 14, **characterized in that** the LED light source (2) is arranged on a carrier (13) comprising the light sensor (14) and/or a signal processing unit (15).

## Revendications

1. Procédé de fabrication d'un codeur de position optique (100) comprenant un composant optoélectronique (1) et un étalon de mesure (101) éclairé par une source de lumière LED (2) du composant optoélectronique (1), dans lequel la source de lumière LED (2) est moulée dans un boîtier moulé (11) de façon à exposer une surface de sortie de lumière (5) de la source de lumière LED (2) à l'extérieur,
**caractérisé en ce que**
la surface de sortie de lumière (5) est pourvue d'un revêtement et est dépourvue du revêtement par zones afin de fournir une fenêtre de sortie de lumière (10).

2. Procédé selon la revendication 1, **caractérisé en ce que** la surface de sortie de lumière (5) est recouverte sur toute la surface ou sur une partie de la surface d'un revêtement (9), notamment sensiblement opaque et/ou réfléchissant.

3. Procédé selon l'une des revendications 1 ou 2, **caractérisé en ce que** la surface de sortie de lumière (5) est recouverte d'un revêtement métallique (9), notamment d'un revêtement (9) en or ou en alliage d'or.

4. Procédé selon l'une des revendications précédentes, **caractérisé en ce qu'**au moins une surface partielle périphérique (6) de la source de lumière LED (2) est pourvue d'un revêtement.

5. Procédé selon la revendication 4, **caractérisé en ce que** l'au moins une surface partielle périphérique (6) de la source de lumière LED (2) et la surface de sortie de lumière (5) sont pourvues d'un revêtement l'une après l'autre.

6. Procédé selon l'une des revendications 4 ou 5, **caractérisé en ce que** la surface de sortie de lumière (5) est recouverte d'un revêtement (9) différent de celui de l'au moins une surface partielle périphérique (6) de la source de lumière LED (2).

7. Procédé selon l'une des revendications précédentes, **caractérisé en ce que** la surface de sortie de lumière (5) est pourvue d'un revêtement par dépôt physique en phase vapeur, notamment par pulvérisation cathodique.

8. Procédé selon l'une des revendications précédentes, **caractérisé en ce que** la surface de sortie de lumière (5) est dépourvue du revêtement par gravure, traitement mécanique et/ou laser.

9. Procédé selon l'une des revendications précédentes, **caractérisé en ce que** la surface de sortie de lumière (5) est pourvue d'un revêtement avant ou après le moulage.

10. Procédé selon l'une des revendications précédentes, **caractérisé en ce que** la surface de sortie de lumière (5) est partiellement dépourvue du revêtement avant ou après le moulage.

11. Codeur de position optique comprenant un composant optoélectronique (1) pourvu d'un boîtier de moulé (11) dans lequel une source de lumière LED (2) est disposée de façon à exposer une fenêtre de sortie de lumière (10) d'une surface de sortie de lumière (5) de la source de lumière LED (2) à l'extérieur, et un étalon de mesure (101) éclairé par la source de lumière LED (2) du composant optoélectronique (1),
**caractérisé en ce que**
la surface de sortie de lumière (5) est partiellement recouverte d'un revêtement (9) de façon à exposer une fenêtre de sortie de lumière (10) à l'extérieur.

12. Codeur de position optique selon la revendication 11, **caractérisé en ce qu'**un côté de la source de lumière LED (2) opposé à la surface de sortie de lumière (5) est un côté de contact (7) de la source de lumière LED (2).

13. Codeur de position optique selon l'une des revendications 11 ou 12, **caractérisé en ce qu'**au moins un capteur de lumière (14) est disposé dans le boîtier de moulé (11).

14. Codeur de position optique selon l'une des revendications 11 à 13, **caractérisé en ce que** la source de lumière LED (2) et/ou le capteur de lumière (14) sont disposés sur un support (13).

15. Codeur de position optique selon l'une des revendications 11 à 14, **caractérisé en ce que** la source de lumière LED (2) est disposée sur un support (13) comprenant le capteur de lumière (14) et/ou une unité de traitement de signal (15).
